# EUROPÄISCHE PATENTSCHRIFT

(11) **EP 1 389 408 B1**
(45) Veröffentlichungstag und Bekanntmachung des Hinweises auf die Patenterteilung: **06.10.2004**
(21) Anmeldenummer: 02758197.4
(22) Anmeldetag: 15.05.2002
(51) Int. Cl.: H05K 3/46

(54) **VERFAHREN ZUR HERSTELLUNG VON BAUELEMENTEN FÜR ELEKTRONISCHE GERÄTE**
METHOD FOR PRODUCING COMPONENTS FOR ELECTRONIC DEVICES
PROCEDE DE FABRICATION DE COMPOSANTS POUR APPAREILS ELECTRONIQUES

(30) Priorität: 21.05.2001 CH 944012001
(43) Veröffentlichungstag der Anmeldung: 18.02.2004
(73) Patentinhaber: Huntsman Advanced Materials (Switzerland) GmbH, 4057 Basel (CH)
(72) Erfinder: EKMAN, Anders, V., S-428 40 Kallered (SE); STÖSSEL, Richard, CH-4132 Muttenz (CH); BECRET, Thierry, F-68730 Blotzheim (FR); TSCHAN, Thierry, F-68870 Bartenheim (FR); STUTZ, Kurt, CH-4142 Münchenstein (CH)
(74) Vertreter: Maué, Paul Georg
(86) Internationale Anmeldenummer: PCT/EP2002/005348
(87) Internationale Veröffentlichungsnummer: WO 2002/096171

(56) Entgegenhaltungen:
- EP-A- 0 275 686
- EP-A- 0 377 332
- DE-A- 19 634 016
- US-A- 5 837 355
- US-A- 6 016 598
- 31512: "LIQUID LAYUP OF PRINTED CIRCUIT BOARDS" RESEARCH DISCLOSURE,KENNETH MASON PUBLICATIONS, HAMPSHIRE,GB, Nr. 315, 1. Juli 1990 (1990-07-01), Seite 542 XP000134124 ISSN: 0374-4353
- RECKERT T: "APPLICATION TECHNOLOGIES FOR COATING LIQUID MICROVIA DIELECTRICS" PROCEEDINGS OF THE TECHNICAL CONFERENCE IPC PRINTED CIRCUITS EXPO, XX, XX, 2. April 2000 (2000-04-02), Seiten S02-1-1-S02-1-6, XP008008615 in der Anmeldung erwähnt

## Beschreibung

Die Erfindung betrifft Verfahren zur Herstellung von Bauelementen für elektronische Geräte mit einem flächigen Trägermaterial, das Vertiefungen und durchgehende Bohrungen aufweist, einer Metallfolie und einer zwischen dem flächigen Trägermaterial und der Metallfolie liegenden Zwischenschicht.

Verschiedene Methoden zur Herstellung von Bauelementen für elektronische Geräte, wie zum Beispiel Leiterplatten sind in der Literatur bereits beschrieben.

Beim RCF (Resin Coated Copper Foil) Verfahren wird eine Kupferfolie mit einem teilweise ausgehärteten und somit festen Harz beschichtet (EP-A 0 935 407). Bei teilvernetzten Harzen wird die Reaktivität durch den festen Zustand lediglich eingeschränkt. Wegen der damit verbundenen Instabilität weisen sie daher nur eine begrenzte Lagerstabilität auf. Durch Verpressen der beschichteten Kupferfolie mit den bereits vorliegenden strukturierten Lagen und anschliessendes Strukturieren erfolgt ein sukzessiver Aufbau der Leiterbahnebenen. Die Fliesseigenschaften des teilvemetzten Harzes unter Druck genügen zwar während dieses Pressvorganges die Leiterbahnenzwischenräume der strukturierten Innenlage zu füllen. Metallisierte Bohrungen und Mikrobohrungen werden dagegen nicht ausreichend gefüllt. Vollständig verschlossene Bohrungen und Mikrobohrungen sind jedoch zwingend notwendig, um die hohen Zuverlässigkeitsanforderungen an hochwertige Leiterplatten sicherzustellen. Daher wird das Verschliessen von Bohrungen vor dem Verpressungsprozess durch zusätzliche zeit- und kostenintensive Prozessschritte sichergestellt. Ferner werden für eine flexible Leiterplattenfertigung verschiedene Harzschichtdicken zwischen den Leiterbahnen benötigt. Bei dem RCF-Verfahren ist dazu die Lagerhaltung von RCF-Folien mit verschiedenen Harzschichtdicken mit eingeschränkter Lagerzeit notwendig, was ein entscheidender wirtschaftlicher Nachteil ist.

Die Rollamination mit harzbeschichteten Kupferfolien (APL-D Verfahren) stellt eine Spezialanwendung des RCF-Verfahrens dar und weist die gleichen Vorteile und Nachteile auf, wie das RCF-Verfahren. Das Rollaminationsverfahren hat den Vorteil eines kontinuierlichen Prozessablaufs, während das RCF-Verfahren ein arbeitsintensiver und damit teurer Batch-Prozess ist (APL-D: Ein einfacher Weg zu SBU-Schaltungen, Galvanotechnik 89 (1998) Nr. 7, Seite 2407 und APL-D, ein neues Verfahren zur Herstellung von Microvia-Leiterplatten, J. Willuweit, Isola AG, Düren).

Im Hotmelt-Verfahren (EP-B 0 698 233) wird das bei erhöhter Temperatur verflüssigte und reaktionsfähige Festharz durch Walzenapplikation auf die mit Kupferleiterbahnen strukturierte Innenlage kontinuierlich aufgebracht. Die Verkupferung kann durch anschliessende Rollamination mit Kupferfolien oder durch nasschemische Schritte realisiert werden. Limitierte Lagerzeit sowie eingeschränkte Stabilität während der Verarbeitungszeit in der Schmelze schränken die Applikation stark ein. Das Verschliessen von Bohrlöchern und das Ausgleichen von Leiterbahnenzwischenräumen sowie eine gute Planarität ist grundsätzlich möglich. Das Füllen von Hohlräumen hängt jedoch stark von der Viskosität und damit der Verarbeitungstemperatur ab. Erhöhte Temperatur führt zu geringerer Viskosität der Schmelze und damit zu einem besseren Fliessverhalten, aber auch zu stark eingeschränkten Verarbeitungszeiten durch die erhöhte Reaktivität.

Im Trockenfilmprozess wird ein noch nicht vernetztes, weitgehend lösungsmittelfreies, härtbares Harzgemisch auf einer später zu entfernenden nichtmetallischen Trägerfolie auf strukturierte Leiterbahnlagen auflaminiert (Praxiserfahrungen bei der Microvia-Technologie, Dr. Hayao Nakahara, PLUS, Seite 324, Absatz 1). Für die Verbindung mit dem Kupfer der nächsten Leiterbahnschicht ist vor dem galvanischen Verkupferungsprozess ein Aufrauhungsprozess der ausgehärteten Oberfläche notwendig. Eine ausreichende Kupferhaftung wird durch alle vorangehenden Verarbeitungsprozesse und Schwankungsbreiten beeinflusst und ist nur aufwendig kontrollierbar.

In Materials for Sequential Build Up (SBU) of HDI-Microvia Organic Substrates, Ceferino, G. Gonzales, The Board Authority March 2000 und in Applicaton Technologies for Coating Liquid Microvia Dielectrics, Torsten Reckert, Proceeding of Technicl Conference IPC printed Circuit Expo 2000 werden flüssige, thermisch reaktive, in Lösungsmittel gelöste, aber bei den Verarbeitungsbedingungen noch nicht vernetzte Harze beschrieben, die auf eine Innenlage aufgebracht werden. Die lösungsmittelhaltige Schicht wird getrocknet und ausgehärtet. Die gehärtete Schicht muss (wie beim gehärteten Trockenfilm) aufgerauht werden um eine ausreichende Kupferhaftung zu erzielen. Die nasschemischen Aufrauhund Verkupferungprozesse sind aufwendig und schwer kontrollierbar. Die erzielbare Planarität ist ungenügend und macht vor dem Aufrauh- und Verkupferungsprozess teure Schleifprozesse notwendig.

In der US-A-6,016,598 wird die Verwendung von fliessfähigen Klebern für das Verbinden eines auf den Oberflächen mit Leiterbahnen versehenen Kernsubstrats mit der Kunststoffseite eines mit Kupferfolien beschichteten Kunststoffsubstrats unter Ausfüllen von Hohlräumen zwischen den Leiterbahnen während des Verpressens und Härtens der Klebschicht beschrieben. Bei den Klebern kann es sich um gegebenenfalls vorreagierte Epoxidharze handeln, die als Lösung aufgetragen werden können, wobei das Lösungsmittel vor dem Laminieren entfernt wird. Die Anwendung von reaktiven Zweikomponentensystemen zur Erzeugung der Klebschicht wird jedoch nicht erwähnt.

In der EP-A-0 275 686 wird ein schichtweiser Aufbau zur Herstellung von Leiterplatten beschrieben, bei dem Kupferfolien mit Epoxidharzen auf ein Substrat mit Leiterbahnen laminiert werden. Die Kontaktierung der Leiterbahnen wird durch nachträgliche Bohrungen vorgenommen, so dass sich bei dieser Herstellungsart das Problem des Ausfüllens von Löchern nicht stellt.

Eine isolierende Harzzusammensetzung und ein Verfahren zur Herstellung von Vielschicht-Platinen sind aus DE-A-19634016 bekannt.

Die Anwendung flüssiger, Iösungsmittelhaltiger und thermisch härtbarer Zusammensetzungen in Form von reaktiven Systemen aus zwei Komponenten zur Erzeugung einer Isolier- und Haftschicht für Metallfolien bei der Herstellung von zum Beispiel gedruckten Schaltungen ist bisher wegen deren geringen Lagerstabilität vermieden worden. Es wurde nun überraschend gefunden, dass man solche Zusammensetzungen einsetzen kann, wenn man sie erst vor der Anwendung formuliert, auf ein Trägermaterial aufbringt und das Lösungsmittel praktisch vollständig entfernt, so dass sich eine feste und trockene Schicht bildet. Die trockene Schicht ist überraschend so fliessfähig, so dass nach Aufbringen einer Metallfolie und nachfolgender Aushärtung unter Druck überraschend Vertiefungen und Löcher vollständig gefüllt und zudem eine ausserordentlich hohe Planarität erzielt werden, so dass eine Nachbearbeitung unnötig ist. Die getrocknete Schicht bleibt trotz Erwärmung härtbar und unter Druck und Erwärmung laminierte Metallfolien bilden einen Verbund mit überraschend hohen Haftfestigkeiten von Metallfolie und Trägermaterial. Die erhaltenen Laminate genügen den gestellten hohen Anforderungen. Ferner ist das Verfahren sehr wirtschaftlich und kann sogar automatisiert werden, so dass insgesamt die geschilderten Nachteile vermieden werden können.

Gegenstand der Erfindung ist ein Verfahren zur Herstellung von Bauelementen für elektronische Geräte aus einem flächigen Trägermaterial, das durchgehende Bohrungen und Vertiefungen auf wenigstens einer Oberfläche aufweist, einer Zwischenschicht auf wenigstens einer Oberfläche des Trägermaterials, und einer auf besagter Schicht haftenden Metallfolie, umfassend die Schritte (a) Beschichten eines flächigen Trägermaterials mit einer die Zwischenschicht bildenden Zusammensetzung, (b) Aufbringen der Metallfolie auf die Beschichtung und (c) Verbinden der Teile unter Druck und Erwärmen, dadurch gekennzeichnet, dass man
(d) zuerst ein flüssiges, ein Lösungsmittel enthaltendes und thermisch härtbares Zweikomponentensystem aus wenigstens einem Härter und wenigstens einer härtbaren Verbindung formuliert,
(e) die Formulierung als Schicht auf wenigstens eine Oberfläche des Trägermaterials aufbringt,
(f) die aufgebrachte Schicht erwärmt, das Lösungsmittel entfernt und eine feste und trockene Schicht bildet, und
(g) danach eine Metallfolie auf die getrocknete Schicht aufbringt und das Trägermaterial, die Schicht und die Metallfolie mittels erhöhter Temperatur und erhöhtem Druck unter Härtung der Schicht fest miteinander verbindet.

Unter dem Ausdruck Bauelemente werden Bauelemente verstanden, die einen Einsatz in der Elektronik finden, wie zum Beispiel Leiterplatten oder optoelektronische Bauelemente.

Unter dem Ausdruck flächiges Trägermaterial wird ein strukturiertes Flächengebilde verstanden, das als Träger fungiert. Dieses kann biegsam oder starr sein. Beispiele dafür sind Folien oder Innenlagen. Strukturierte Innenlagen werden oft verwendet. Die strukturierte Innenlage kann beispielsweise eine Isolationsschicht enthalten, die auf der Leiterbahn aufgebracht ist, wobei die Isolationsschicht auch aus einem mit einem Glasfasern verstärkten gehärteten Harz bestehen kann. Bei einer anderen bevorzugten Ausführungsform können elektronische Komponenten wie zum Beispiel Widerstände, Dioden oder Transistoren in oder auf der Oberfläche der Innenlage angeordnet sein. Bei einer anderen besonderen Ausführungsform können optische Elemente wie beispielsweise Photodioden, Photoelemente, Phototransistoren oder Photowiderstände in oder auf der Oberfläche der Innenlage angeordnet sein.

Die Komponenten der Formulierung werden bei Raumtemperatur gelagert und sie sind über längere Zeit ausgesprochen stabil. Die Formulierung wird unmittelbar vor der Applikation durch Mischen der einzelnen Komponenten hergestellt und unmittelbar danach mittels bekannter Verfahren und Vorrichtungen wie Siebdruck, Rollercoating, Vorhanggiessen oder Sprühen auf das flächige Trägermaterial aufgebracht. Das optimale Verfahren kann der Fachmann jeweils durch entsprechende Vorversuche ermitteln. Für das Aufbringen der Beschichtungsformulierung ist insbesondere das Siebdruck- und Rollercoatingverfahren geeignet, da durch die Anwendung von Druck beim Auftragen der Beschichtungsformulierung Hohlräume zuverlässig und vollständig aufgefüllt werden können. Durch entsprechende Anpassung der Beschichtungsparameter, wie zum Beispiel der Viskosität durch Lösungsmittelzugabe, kann der Fachmann leicht die Schichtdicke variieren. Lufteinschlüsse, die leicht zu Schwierigkeiten geführt haben, können leicht mittels Entlüftung eliminiert werden, da die Formulierung mit Lösungsmitteln auf eine niedrige Viskosität eingestellt werden kann. Die Formulierung kann zum Beispiel eine Viskosität von kleiner 20 Pa*s, bevorzugt 3 bis 20 Pa*s, und besonders bevorzugt 5 bis 15 Pa*s aufweisen, gemessen bei 25 °C nach Brookfield.

Nach der Beschichtung des flächigen Trägermaterials mit der Formulierung wird die aufgebrachte Schicht getrocknet. Typische Bedingungen zur Trocknung sind dem Fachmann bekannt. Der Trocknungsprozess wird so angepasst, das der Formulierung das Lösungsmittel entzogen, aber dabei eine Vernetzung des härtbaren Harzes weitgehend vermieden wird. Durch mehrfache Beschichtung kann jede beliebige Zwischenschichtdicke eingestellt werden.

Die Trocknung stellt einen wesentlichen Verfahrensschritt des erfindungsgemässen Verfahrens dar. Die Trocknung muss so vollständig sein, dass beim nachfolgenden Verpressen unter Erwärmen keine Blasenbildung erfolgt. Während der Trocknung muss eine vorzeitige Härtung der Schicht vermieden werden. Hierzu wird die Temperatur und die Zeitdauer während der Trocknung auf die Reaktivität des Zweikomponentensystems abgestimmt. Die geeignete Temperatur kann der Fachmann leicht in Vorversuchen ermitteln. Die Temperatur liegt bei der Trocknung im allgemeinen nicht höher als 100 °C und kann 40 bis 100 °C, bevorzugt 50 bis 80 °C betragen. Die Dauer der Trocknung hängt im wesentlichen von der Flüchtigkeit des Lösungsmittels und der Schichtdicke ab und kann von 10 bis 120, bevorzugt 20 bis 100 und besonders bevorzugt von 30 bis 80 Minuten reichen. Nach der Trocknung liegt eine klebfreie und feste Schicht vor. Der Fluss der getrockneten Schicht ist für die Qualität der Bauelemente für elektronische Geräte ausnehmend wichtig, da dadurch die erwünschte Planarität und das vollständige Verfüllen von Hohlräumen erreicht wird. Die Konsistenz der niedermolekularen Komponenten in der Schicht gewährleistet beim Verpressen und Härten einen hervorragenden Fluss, so dass die gewünschten Eigenschaften problemlos erreicht werden.

Teilbereiche des flächigen Trägermaterials dürfen aus prozesstechnischen Gründen im Aussenbereich nicht beschichtet werden, da diese für das Anbringen der Transportklemmen unbeschichtet bleiben müssen. Während des Pressvorgangs wird die Zwischenschicht sogar auf diese Teilbereiche ausgedehnt, so dass im Endstadium die gesamte Oberfläche bis zum Oberflächenrand mit der Zwischenschicht beschichtet ist. Bei der Trocknung erfolgt eine Abnahme der Schichtdicke. Diese Abnahme kann durch den Fachmann mit Vorversuchen durch höhere Schichtdicken beziehungsweise höhere Konzentration der Komponenten in der Lösung kompensiert werden.

Die Geschwindigkeit des nachfolgenden Härtungsprozesses wird vom Fachmann unter anderem durch die Härterart, die Härtermenge, die Verweildauer, die Temperatur und den Druck gesteuert. Der Fachmann stellt die oben genannten Parameter für den Pressvorgang nach Vorversuchen entsprechend ein. Die Härtung kann indirekt durch die Metallhaftung gemessen werden (Cu-Haftungsmessung nach IPC-TM-650 2.4.8).

Beim Verpressen der getrockneten Zwischenschicht auf dem flächigen Trägermaterial mit Kupferfolien bei erhöhter Temperatur entstehen die Bauelemente. Vorzugsweise wird die Metallfolie unmittelbar nach dem Trocknen auf die Zwischenschicht aufgebracht und verpresst. Die Oberflächenqualität der Pressplatten ist für die Qualität der Bauelemente sehr wichtig, und daher dürfen sich keine Schmutz- und Fremdpartikel zwischen Pressplatten, der Zwischenschicht und der Metallfolie befinden. Typische Pressbedingungen sind zum Beispiel 20 bis 120, bevorzugt 20 bis 80 und besonders bevorzugt 20 bis 60 Minuten bei Temperaturen von 120 bis 200 °C und bevorzugt 140 bis 200 °C zum Beispiel für ein Epoxidharz oder andere Harze. Das Pressen kann auch stufenweise bei steigenden Temperaturen während unterschiedlicher Zeitdauer vorgenommen werden, wobei man mit Temperaturen unter 100 °C, zum Beispiel 80 °C, beginnen kann. Typischere Pressbedingungen für andere Harze sind dem Fachmann bekannt. Beim Pressen werden die geringfügigen Schichtdickenunterschiede ausgeglichen, die durch das Beschichten entstanden und nach dem Trocknen noch vorhanden sind. Als Pressen können Multilayerpressen oder kontinuierlich arbeitende Pressen verwendet werden. In einem Pressvorgang können bei Anwendung von Multilayerpressen, 10 bis 20 Bauelemente für elektronische Geräte gleichzeitig hergestellt werden.

Durch das erfindungsgemässe Verfahren kann die maximale Wölbung und Verwindung auf ein Minimum reduziert werden. Das erfindungsgemäss hergestellte Bauelement ist innerhalb einer Toleranz von 5 µm eben, wobei die Planarität nach IPC-TM-650 2.4.8 bestimmt wird. Ein nachträgliches Abschleifen, um die Planarität zu erreichen, ist nicht mehr notwendig. Damit kann ein nachteiliger Prozess, d.h. ein Prozess, bei dem Material wieder abgetragen wird, eliminiert werden, was sowohl ökologisch als ökonomisch vorteilhaft ist.

Die bei Raumtemperatur flüssige Beschichtungsformulierung enthält wenigstens ein thermisch härtbares Harz, wenigstens einen Härter, gegebenenfalls einen Härtungsbeschleuniger und ein oder mehrere Lösungsmittel. Vorzugsweise wird als Beschichtungsformulierung ein Dielektrikum verwendet. Die Beschichtungsformulierung kann zusätzlich Beschleuniger, Füllstoffe oder Additive enthalten. Die Molekulargewichte der Komponenten liegen vorzugsweise in einem Bereich von 250 bis 8000, bevorzugter 250 bis 5000 und besonders bevorzugt 250 bis 2000 Dalton.

Das Harz bildet im ausgehärteten Zustand eine irreversible, dreidimensionale, polymere Struktur. Durch das erfindungsgemässe Verfahren kann eine Vielzahl von thermisch härtbaren Harzen eingesetzt werden. Besonders bevorzugt werden Harze, die eine erhöhte Glasübergangstemperatur (Tg-Punkt) aufweisen. Besonders bevorzugt werden Harze, deren Tg-Punkte höher oder gleich denen von FR4-Harzen (glasfaserverstärkte Epoxidharze)) sind. Diese Harze sind sehr hart und formstabil. In konventionellen Prozessen sind solche Harze entsprechend schwerer zu verarbeiten. Durch das Wegfallen des Aufrauhprozesses vor der Verkupferung bei der Anwendung des erfindungsgemässen Verfahrens können Harze eingesetzt werden, die mit herkömmlichen chemischen Quellund Ätzverfahren nur schwer aufzurauhen sind.

Bevorzugt wird das verwendete härtbare Harz ausgewählt aus der Gruppe der Epoxidharze, Epoxyacrylatharze, Acrylatharze, Polyurethanharze, Cyanatesterharze, Benzoxazinharze, Polyphenylenharze, Polyimidharze und Mischungen davon. Besonders bevorzugt sind Epoxidharze. Ihre chemische Beständigkeit und die ausgezeichneten Haftungseigenschaften machen sie besonders geeignet. Besonders bevorzugt sind aromatische Epoxidharze. Beispiele für Epoxidverbindungen mit durchschnittlich mehr als einer Epoxidgruppe im Molekül sind:
I) Polyglycidyl- und Poly-(β-methylglycidyl)-ester, erhältlich durch Umsetzung einer Verbindung mit mindestens zwei Carboxylgruppen im Molekül und Epichlorhydrin bzw. β-Methylepichlorhydrin. Die Umsetzung erfolgt zweckmässig in der Gegenwart von Basen.
   Als Verbindung mit mindestens zwei Carboxylgruppen im Molekül können aliphatische Polycarbonsäuren verwendet werden. Beispiele für solche Polycarbonsäuren sind Oxalsäure, Bernsteinsäure, Glutarsäure, Adipinsäure, Pimelinsäure, Korksäure, Azelainsäure oder dimerisierte bzw. trimerisierte Linolsäure.
   Es können aber auch cycloaliphatische Polycarbonsäuren eingesetzt werden, wie beispielsweise Tetrahydrophthalsäure, 4-Methyltetrahydrophthalsäure, Hexahydrophthalsäure oder 4-Methylhexahydrophthalsäure.
   Weiterhin können aromatische Polycarbonsäuren Verwendung finden, wie beispielsweise Phthalsäure, Isophthalsäure oder Terephthalsäure.
II) Polyglycidyl-oder Poly-(β-methylglycidyl)-ether, erhältlich durch Umsetzung einer Verbindung mit mindestens zwei freien alkoholischen Hydroxygruppen und/oder phenolischen Hydroxygruppen mit Epichlorhydrin oder β-Methylepichlorhydrin unter alkalischen Bedingungen oder in Anwesenheit eines sauren Katalysators mit anschliessender Alkalibehandlung.
   Die Glycidylether dieses Typs leiten sich beispielsweise von acyclischen Alkoholen ab, z.B. von Ethylenglykol, Diethylenglykol oder höheren Poly-(oxyethylen)-glykolen, Propan-1,2-diol oder Poly-(oxypropylen)-glykolen, Propan-1,3-diol, Butan-1,4-diol, Poly-(oxytetramethylen)-glykolen, Pentan-1,5-diol, Hexan-1,6-diol, Hexan-2,4,6-triol, Glycerin, 1,1,1-Trimethylolpropan, Pentaerythrit, Sorbit, sowie von Polyepichlorhydrinen.
   Weitere Glycidylether dieses Typs leiten sich ab von cycloaliphatischen Alkoholen, wie 1,4-Cyclohexandimethanol, Bis-(4-hydroxycyclohexyl)-methan oder 2,2-Bis-(4-hydroxycyclohexyl)-propan, oder von Alkoholen, die aromatische Gruppen und/oder weitere funktionelle Gruppen enthalten, wie N,N-Bis-(2-hydroxyethyl)-anilin oder p,p'-Bis-(2-hydroxyethylamino)-diphenylmethan.
   Die Glycidylether können auch auf einkernigen Phenolen, wie beispielsweise Resorcin oder Hydrochinon, oder auf mehrkemigen Phenolen, wie beispielsweise Bis-(4-hydroxyphenyl)-methan, 4,4'-Dihydroxybiphenyl, Bis-(4-hydroxyphenyl)-sulfon, 1,1,2,2-Tetrakis-(4-hydroxyphenyl)-ethan, 2,2-Bis-(4-hydroxyphenyl)-propan oder 2,2-Bis-(3,5-dibrom-4-hydroxyphenyl)-propan, basieren.
   Weitere geeignete Hydroxyverbindungen zur Herstellung von Glycidylethern sind Novolake, erhältlich durch Kondensation von Aldehyden, wie Formaldehyd, Acetaldehyd, Chloral oder Furfuraldehyd, mit Phenolen oder Bisphenolen, die unsubstituiert oder mit Chloratomen oder C₁-C₉-Alkylgruppen substituiert sind, wie beispielsweise Phenol, 4-Chlorphenol, 2-Methylphenol oder 4-tert.-Butylphenol.
III) Poly-(N-glycidyl)-verbindungen, erhältlich durch Dehydrochlorierung der Reaktionsprodukte von Epichlorhydrin mit Aminen, die mindestens zwei Aminwasserstoffatome enthalten. Bei diesen Aminen handelt es sich zum Beispiel um Anilin, n-Butylamin, Bis(4-aminophenyl)-methan, m-Xylyfendiamin und Bis-(4-methylaminophenyl)-methan.
   Zu den Poly-(N-glycidyl)-verbindungen zählen auch Triglycidylisocyanurat, N,N'-Di-glycidylderivate von Cycloalkylenhamstoffen, wie Ethylenharnstoff oder 1,3-Propylenharnstoff, und Diglycidylderivate von Hydantoinen, wie von 5,5-Dimethylhydantoin.
IV) Poly-(S-glycidyl)-verbindungen, beispielsweise Di-S-glycidylderivate, die sich von Dithiolen, wie beispielsweise Ethan-1,2-dithiol oder Bis-(4-mercaptomethylphenyl)-ether, ableiten.
V) Cycloaliphatische Epoxidharze, wie beispielsweise Bis-(2,3-epoxycyclopentyl)-ether, 2,3-Epoxycyclopentylglycidylether, 1,2-Bis-(2,3-epoxycyclopentyloxy)-ethan oder 3,4-Epoxycyclohexylmethyl-3',4'-epoxycyclohexancarboxylat.

Es lassen sich auch Epoxidharze verwenden, bei denen die 1,2-Epoxidgruppen an unterschiedliche Heteroatome bzw. funktionelle Gruppen gebunden sind; zu diesen Verbindungen zählen beispielsweise das N,N,O-Triglycidylderivat des 4-Aminophenols, der Glycidylether-glycidylester der Salicylsäure, N-Glycidyl-N'-(2-glycidyloxypropyl)-5,5-dimethylhydantoin und 2-Glycidyloxy-1,3-bis-(5,5-dimethyt-1-giycidylhydantoin-3-yl)-propan.

Bevorzugt verwendet man zur Beschichtung Zusammensetzungen, die nach der Trocknung eine feste Schicht bilden. Die Bildung einer festen Schicht kann durch die Auswahl der Bestandteile der gesamten Zusammensetzung oder einer Vorreaktion bei der Trocknung gesteuert werden, was der Fachmann durch einfaches ausprobieren feststellen kann. Bevorzugte Beispiele für feste Polyepoxide sind feste Polyglycidylether oder -ester, insbesondere feste Diglycidylether eines Bisphenols oder feste Diglycidylester einer cycloaliphatischen oder aromatischen Dicarbonsäure, oder ein festes cycloaliphatisches Epoxidharz. Ferner sind feste Epoxidnovolake besonders geeignet. Es können auch Gemische von Epoxidharzen verwendet werden.

Als Härter für die härtbaren Epoxidharze in der Beschichtungsformulierung können alle bekannten Härter eingesetzt werden, wenn sie zusammen mit den anderen Bestandteilen nach Entfernen des Lösungsmittels eine trockene Schicht bilden. Die Bildung einer trockenen Schicht kann der Fachmann wie zuvor ausgeführt in einfacher Weise ausprobieren. Härter für Epoxidharze sind bevorzugt ausgewählt aus der Gruppe der basischen Härter, wobei stickstoff- und phosphorhaltige Härter besonders bevorzugt sind, wie zum Beispiel Imidazole, Amide und Polyamine. Des Weiteren sind auch Phenolharze, Polycarbonsäuren und deren Anhydride, und Cyanatester geeignet.

Beispiele für Härter in Kombination mit Epoxidverbindungen sind Polycarbonsäuren, Polyamine, Polyaminoamide, Aminogruppenhaltige Addukte aus einem Amin und einer Polyepoxidverbindung, aliphatische und aromatische Polyole und katalytisch wirkende Härtungsmittel.

Als geeignete Polycarbonsäuren seien beispielsweise genannt: Aliphatische Polycarbonsäuren, wie Maleinsäure, Oxalsäure, Bemsteinsäure, Nonyl- oder Dodecylbemsteinsäure, Glutarsäure, Adipinsäure, Pimelinsäure, Korksäure, Azelainsäure oder dimerisierte bzw. trimerisierte Linolsäure; cycloaliphatische Polycarbonsäuren, wie beispielsweise Tetrahydrophthalsäure, Methylendomethylentetrahydrophthalsäure, Hexachlorendomethylentetrahydrophthalsäure, 4-Methyltetrahydrophthalsäure, Hexahydrophthalsäure oder 4-Methylhexahydrophthalsäure, oder aromatische Polycarbonsäuren, wie beispielsweise Phthalsäure, Isophthalsäure, Terephthalsäure, Trimellitsäure, Pyromellitsäure oder Benzophenon-3,3',4,4'-tetracarbonsäure, sowie die Anhydride der genannten Polycarbonsäuren.

Als Polyamine können für die Härtung aliphatische, cycloaliphatische, aromatische oder heterocyclische Amine eingesetzt werden, wie beispielsweise Ethylendiamin, Propan-1,2-diamin, Propan-1,3-diamin, N,N-Diethylethylen-diamin, Hexamethylendiamin, Diethylentriamin, Triethyleritetramin, Tetraethylenpentamin, N-(2-Hydroxyethyl)-, N-(2-Hydroxypropyl)- und N-(2-Cyanoethyl)-diethyltriamin, 2,2,4-Trimethylhexan-1,6-diamin, 2,3,3,-Trimethylhexan-1,6-diamin, N,N-Dimethyl- und N,N-Diethylpropan-1,3-diamin, Ethanolamin, mund p-Phenylendiamin , Bis-(4-aminophenyl)-methan, Anilin-Formaldehyd-Harz, Bis-(4-aminophenyl)-sulfon, m-Xylylendiamin, Bis-(4-aminocyclohexyl)-methan, 2,2-Bis-(4-aminocyclohexyl)-propan, 2,2-Bis-(4-amino-3-methylcyclohexyl)-propan, 3-Aminomethyl-3,5,5-trimethylcyclohexylamin (Isophorondiamin) und N-(2-Aminoethyl)-piperazin, sowie als Polyaminoamide beispielsweise solche aus aliphatischen Polyaminen und dimerisierten oder trimerisierten Fettsäuren.

Als Polyaminoamide eignen sich beispielsweise die durch Umsetzung von Polycarbonsäuren, vorzugsweise von dimerisierten Fettsäuren, mit Polyaminen im molaren Überschuss erhaltenen Reaktionsprodukte, wie sie beispielsweise im Handbook of Epoxy Resins, 1967, Seiten 10-2 bis 10-10, von H. Lee und K. Neville beschrieben werden.

Aminogruppenhaltige Addukte aus einem Amin und einer Polyepoxidverbindung als Härtungsmittel für Epoxidharze sind ebenfalls bekannt und können für die Härtung der erfindungsgemässen Epoxidharzzusammensetzungen eingesetzt werden und werden beispielsweise durch Umsetzung von Epoxidharzen mit Polyaminen im äquivalenten Überschuss erhaltenen. Solche aminogruppenhaltige Addukte werden beispielsweise in den US-Patenten 3,538,184; 4,330,659; 4,500,582 und 4,540,750 näher beschrieben.

Als aliphatische Polyole für die Härtung der erfindungsgemässen Epoxidharzzusammensetzungen eignen sich beispielsweise Ethylenglykol, Diethylenglykol und höhere Poly-(oxyethylen)-glykole, Propan-1,2-diol oder Poly-(oxypropylenrglykole, Propan-1,3-diol, Butan-1,4-diol, Poly-(oxytetramethylen)-glykole, Pentan-1,5-diol, Hexan-1,6-diol, Hexan-2,4,6-triol, Glycerin, 1,1,1-Trimethylolpropan, Pentaerythrit, Sorbit, N,N-Bis-(2-hydroxyethyl)-anilin oder p,p'-Bis-(2-hydroxyethylamino)-diphenylmethan.

Als aromatische Polyole können für die Härtung beispielsweise einkernige Phenole, wie Resorcin, Hydrochinon, oder mehrkernige Phenole, wie Bis-(4-hydroxyphenyl)-methan, 4,4'-Dihydroxybiphenyl, Bis-(4-hydroxyphenyl)-sulfon, 1,1,2,2-Tetrakis-(4-hydroxyphenyl)-ethan, 2,2-Bis-(4-hydroxyphenyl)-propan, 2,2-Bis-(3,5-dibrom-4-hydroxyphenyl)-propan sowie Novolake, erhältlich durch Kondensation von Aldehyden, wie Formaldehyd, Acetaldehyd, Chloral oder Furfuraldehyd, mit Phenolen, wie Phenol, oder mit Phenolen, die im Kern mit Chloratomen oder C₁-C₉-Alkylgruppen substituiert sind, wie beispielsweise 4-Chlorphenol, 2-Methylphenol, oder 4-tert.-Butylphenol oder durch Kondensation mit Bisphenolen, beispielsweise solche der oben genannten Art, eingesetzt werden.

Es können auch katalytisch wirkende Härtungsmittel zur Härtung der erfindungsgemässen Epoxidharzzusammensetzungen verwendet werden, wie tertiäre Amine, beispielsweise 2,4,6-Tris-(dimethylaminomethyl)-phenol und andere Mannichbasen, N-Benzyldimethylamin und Triethanolamin; Alkalimetallalkoxide von Alkoholen, beispielsweise Na-alkoholat von 2,4-Dihydroxy-3-hydroxymethylpentan; Zinnsalze von Alkansäuren, beispielsweise Zinnoctanoat; Friedel-Crafts-Katalysatoren, beispielsweise Bortrifluorid und seine Komplexe, beispielsweise Bortrifluorid-Amin-Komplexe, und Chelate, die durch Umsetzung von Bortrifluorid mit zum Beispiel 1,3-Diketonen erhalten werden, Sulfoniumsalze, wie sie beispielsweise im EP-Patent 0 379 464 oder US-Patent 5,013.814, im EP-Patent 0 580 552 oder US-Patent 5,374,697 offenbart werden, oder heterocylische Ammoniumsalze, zum Beispiel Chinoliniumsalze gemischt mit Benzpinakol, wie sie beispielsweise in EP-A-0 066 543 erwähnt sind.

Als Härter können auch durch Bestrahlung aktivierbare Initiatoren eingesetzt werden, die nach der Bestrahlung als thermische Härter wirken, insbesondere in Kombination mit Epoxidverbindungen. In diesem Fall werden die aufgebrachten Schichten nach der Trocknung und vor dem Laminieren mit einer Metallfolie mit Licht, vorzugsweise UV-Licht bestrahlt. Solche Initiatoren werden bevorzugt ausgewählt aus der Gruppe der Aryldiazoniumsalze, Diaryliodoniumsalze wie zum Beispiel Diphenyliodoniumtetrafluoroborate und ähnliche, Triarylsulfoniumsalze wie zum Beispiel Triphenylsulfoniumhexafluoroantimonat und ähnliche, Arylacyldialkylsulfoniumsalze, 1,2-Quinondiazidcarbonsäure-4-ester, 1,2-Quinondiazidesulfonsäure-4-ester, 4-(2-Ethylhexanoyl)-resorcinol-1,2-naphtoquinonediazid-4-sulfonsäureester und ähnliche sowie Eisenaren-Komplexe. Letztere sind Verbindungen der Formel

[R¹(Fe^{II}R²)]⁺[X]⁻

wobei R¹ ein π-Aren und R² ein π-Aren oder ein π-Aren-Anion darstellt. Bevorzugt ist dabei R¹ ein η⁶-Cumol, η⁶-Naphthalin, η⁶-Benzol oder η⁶-Pyrol. R² steht vorzugsweise für ein η⁵-Cyclopentadien. X steht für ein nicht nucleophiles Anion. Besonders bevorzugte Beispiele von X umfassen BF₄⁻, PF₆⁻, AsF₆⁻, SbF₆⁻, SbF₅OH⁻, Sulfonate wie Methylsulfonat, p-Tolylsulfat und ähnliche, Perfluoroalkylsulfonate wie zum Beispiel Trifluoromethylsulfonate, Nonafluorobutylsulfonate und ähnliche, Acetate wie CH₃COO⁻ und ähnliche, Perfluoroacetate wie CF₃COO⁻ und ähnliche, Halogene wie F⁻, Cl⁻, Br⁻, I⁻ und ähnliche, Pseudohalogene wie CN⁻, SCN⁻ und ähnliche. Vorzugsweise steht X für ein Sulfonat, ein Perfluorosulfonate oder PF₆⁻. Es ist dem Fachmann bekannt, dass radikalische, anionische und kationische Initiatoren bei ihrem thermischen Zersetzungspunkt ohne Licht thermische Zersetzungsreaktionen starten können. Durch geschickte Auswahl der Zersetzungsreaktion der Initiatoren lässt sich die Härtungstemperatur während des Pressprozesses einstellen beziehungsweise während des Trocknungsprozesses unterdrücken.

Thermische und photochemische Härter können auch mit Beschleuniger eingesetzt werden. Bevorzugte Beschleuniger sind Benzyldimethylamin, 2-Phenylimidazol und 2-Methylimidazol, das zur Erhöhung des Tg-Punktes (Glasübergangstemperatur) und/oder zur schnelleren Aushärtung zugesetzt wird. Je höher der Tg-Punkt ist, umso höher ist die Temperatur, bei der das Polymer von einem glasförmigen in einen nahezu elastomeren Zustand übergeht. Der Fachmann kann aufgrund seiner Kenntnisse den Tg-Punkt so einstellen, dass Dimensionsänderungen, Verwerfungen und Verwindungen der Zwischenschicht vermieden werden.

Geeignete Lösungsmittel in der Beschichtungsformulierung sind polare, insbesondere polare, aprotische Lösungsmittel. Die Lösungsmittel können alleine oder als Mischung mit anderen Lösungsmitteln verwendet werden. Mögliche Lösungsmittel sind: Ether, halogenierte Kohlenwasserstoffe, Carbonsäureester, Lactone, Sulfone, Ketone und substituierte Benzole. Besonders bevorzugt sind Diethylenglykol-Ethylether-Acetat und Dipropylenglykol-Methylether und Mischungen davon.

Füllstoffe werden der Beschichtungsformulierung häufig zugegeben. Beispiele dafür anorganische Füllstoffe wie Bariumsulfat, Bariumtitanat, Siliziumoxid, Talk, Calciumcarbonat, Calciummagnesiumcarbonat, Ammoniumphosphate, Glimmer, Magnesiumhydroxid, Aluminiumhydroxide und ähnliche oder organische Füllstoffe wie Siliconpulver, Nylonpulver, Mikrogele, Fluoridpulver und ähnliche.

Falls nötig, werden der Beschichtungsformulierung auch Additive zugegeben. Beispiele dafür sind Thixotropiemittel wie Aerosil, Orben, Benton, Montmorillonit und ähnliche.

Weitere Additive, die vorzugsweise in der Beschichtungsformulierung vorhanden sind, sind Entschäumungsmittel und Farbstoffe, wie Phthalocyaninblau, Phthalocyaningrün, Kristallviolett, Titaniumoxid und ähnliche.

Für die Beschichtung können verschiedene Metallfolien mit ausreichender Leitfähigkeit verwendet werden, besonders bevorzugt werden Kupferfolien. Andere bevorzugt verwendete Metallfolien sind solche aus Aluminium, aus Kupferlegierungen sowie solche aus hochtemperaturbeständigen Metallen wie Nickel. Die Kupferfolien können in beliebigen Stärken verwendet werden. Bevorzugt sind Folien mit einer Dicke grösser 10 µm. Die untere Begrenzung ist durch die mechanische Stabliliät der Folien gegeben. Durch den Einsatz von Trägerfolien können auch dünnere Folien verwendet werden. Beispiele für solche Trägerfolien sind Aluminium-Kupferfolien.

Kupferfolien geringerer Stärke erlauben die direkte Bohrung/Strukturierung durch Laserablation. Dafür kann eine auf der Metallfolie aufgebrachte, die Absorption erhöhende oder die Reflexion des Laserlichtes erniedrigende Schicht aufgebracht werden. Ein Beispiel dafür ist eine Kupferoxidschicht, die eine direkte Verwendung von CO₂-Lasern ermöglicht. Zeit- und kostenaufwendige nasschemische Ätzverfahren (Window-Etching-Verfahren) zur Kupferstrukturierung oder -bohrung sind dadurch nicht mehr notwendig. Durch das Aufbringen der Kupferfolie auf die Zwischenschicht ist kein nass/plasmachemischer Aufrauhprozess mehr notwendig. Dadurch können die verschiedensten härtbaren Harze für das erfindungsgemässe Verfahren verwendet werden.

Durch das erfindungsgemässe Verfahren hergestellte Bauelemente für elektronische Geräte haben ausgezeichnete mechanische, chemische und elektrische Eigenschaften und lassen sich zudem kostengünstig herstellen.

Eine durch das erfindungsgemässe Verfahren erhaltene Leiterplatte ist für weitere Verfahrensschritte wie Laserbohren, Strukturieren des Kupfers, flash-etching für direktes Laserbohren mit CO₂-Lasern, window-etching bereit. Durch das erfindungsgemässe Verfahren kann die Fertigungstoleranz massiv gesenkt werden, was wiederum zu starken Kosteneinsparungen bei den nachfolgenden Prozessen führen kann. Die durch das erfindungsgemässe Verfahren hergestellten Leiterplatten vereinfachen die Anwendung neuer Technologien, wie zum Beispiel neue Bondtechniken wie Flipchipattachment. Ferner kann Material eingespart werden, wie zum Beispiel durch die Reduktion der Lötstoppmaskenschichtdicke.

Die Erfindung wird nachstehend anhand einiger Figuren näher erläutert. Dabei zeigen:
- Figur 1: den Aufbau einer strukturierten Innenlage;
- Figur 2: die strukturierte Innenlage nach Beschichtung mit einer Beschichtungsformulierung und Trocknung derselben und
- Figur 3: eine fertige nach dem erfindungsgemässen Verfahren hergestellte Leiterplatte.

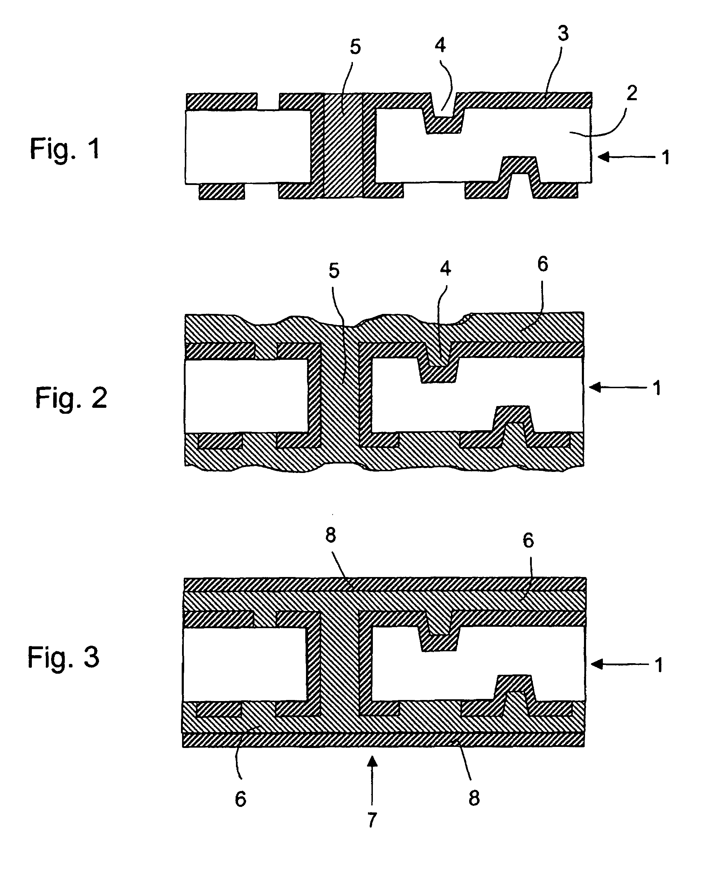

Figur 1 zeigt den Aufbau einer strukturierten Innenlage 1. Dabei sind Leiterbahnen 3 auf einer Isolationsschicht 2 aufgebracht. Die Isolationsschicht 2 ist durch Durchsteiger 5 und Mikrobohrungen 4 strukturiert, wobei diese mittels konventionellem Bohren erzeugt werden. Die Durchsteiger 5 und Mikrobohrungen 4 sind ebenfalls verkupfert und ein integraler Bestandteil der Leiterbahnen 3. Die Isolationsschicht 2 besteht vorzugsweise aus einem mit einem Glasfasergeflecht verstärkten härtbaren Harz, z.B. Epoxidharz. Diese Isolationsschicht 2 ist unter dem Begriff PREPEG bekannt. Besonders bevorzugt ist dabei das FR4 Epoxidharz verstärkt mit einem Glasfasergeflecht.

Figur 2 zeigt die strukturierte Innenlage 1 nach der Beschichtung mit der Beschichtungsformulierung 6 und Trocknung derselben. Die Beschichtungsformulierung 6 wird mit einem oben beschriebenen Verfahren auf die strukturierte Innenlage aufgebracht. Dabei werden die Durchsteiger 4 und Mikrobohrungen 5 gefüllt. Nach der Beschichtung der strukturierten Innenlage 1 mit der Beschichtungsformulierung 6 wird diese getrocknet.

Figur 3 zeigt die nach dem erfindungsgemässen Verfahren hergestellte Leiterplatte 7. Auf die Zwischenschicht 6 auf der strukturierten Innenlage 1 wird eine Metallfolie 8 aufgebracht und dieselben bei erhörter Temperatur verpresst, wobei die Härtung des härtbaren Harzes erfolgt. Durch die Verpressung wird die Zwischenschicht 6 planar.

Die nachfolgenden Beispiele erläutern die Erfindung näher.

### Beispiel 1:

Zusammensetzung der Beschichtungsformulierung

| | |
|---|---|
| Avancierter Bisphenol-A-glycidylether | 40.00% |
| Epoxyphenolnovolak | 10.00% |
| Thixotropiemittel auf Kieselsäurebasis | 1.00% |
| Füller, CaMgCO₃ | 20.00% |
| Diethylenglykol-Ethylether-Acetat | 25.00% |
| Phenylimidazol | 0.5% |
| Kresolnovolack | 3.00% |
| Additive | 0.2% |
| Total | 100.00% |

Die Beschichtungsformulierung weist eine Viskosität von 10 Pa.s auf.

Es wird eine einseitig strukturierte Kupferfolie der Stärke 12 µm verwendet.

Die strukturierte Innenlage wird mit der obigen Beschichtungsformulierung mittels eines Furnace Roller Coaters beschichtet. Die Doppelbeschichtung erfolgt mit einer 800 Rolle (= 800 µm Riffelung). Die Beschichtungsformulierung wird 60 Minuten bei 80°C getrocknet.

Als Presse dient eine Multilayerpresse von der Firma Cedal mit induktiver Heizung (Adara Mod. 57). Bei dieser Presse kann das Heiz- und Druckprofil individuell eingestellt werden. Folgende Parameter werden verwendet:
10 Minuten auf 80°C bei 4 kg/cm²,
25 Minuten auf 130°C bei 4 kg/cm²,
9 Minuten auf 175°C bei 10 kg/cm²,
20 Minuten auf 185°C bei 10 kg/cm².

Die erfindungsgemässe Leiterplatte hat eine Kupferhaftung > 14 N/cm (Cu-Haftungsmessung nach IPC-TM-650 2.4.8), eine Planarität < 5µm (Planaritätsermittlung mittels IPC-TM-650 2.2.21), eine Schichtdickenverteilung < 5µm. Die Glasumwandlungstemperatur des gehärteten Harzes in der Beschichungsformulierung ist bei 120°C (mittels TMA ermittelt).

### Beispiel 2:

Zusammensetzung der Beschichtungsformulierung:

| | |
|---|---|
| Avancierter Bisphenol-A-glycidether | 30.00% |
| Epoxyphenolnovolak | 9.00% |
| Thixotropiemittel auf Kieselsäurebasis | 0.70% |
| Füller, CaMgCO₃ | 15.00% |
| Diethylenglykol-Ethylether-Acetat | 25.00% |
| Kupfer-II.Naphtenate (8% Cu) | 0.1% |
| Bisphenol-A-Cyanatester | 20.00% |
| Additive | 0.2% |
| Total | 100.00% |

Die Beschichtungsformulierung weist eine Viskosität von 10 Pa·s auf.

Es wird eine einseitig strukturierte Kupferfolie der Stärke 36 µm verwendet.

Die strukturierte Innenlage wird mit der obigen Beschichtungsformulierung mittels Rakelbeschichtung beschichtet. Die Doppelbeschichtung erfolgt mit einer 100 µm Rakel. Die Beschichtungsformulierung wird 60 Minuten bei 80°C getrocknet.

Die Verpressung erfolgt 60 Minuten bei 150°C bei 10 kg/cm² in einer Presse (Hersteller Carver, Modell C, 15x15 cm, heizbar).

Die erfindungsgemässe Leiterplatte hat eine Kupferhaftung > 14 N/cm (Cu-Haftungsmessung nach IPC-TM-650 2.4.8), eine Planarität < 5µm (Planaritätsermittlung mittels IPC-TM-650 2.2.21), eine Schichtdickenverteilung < 5µm. Die Glasumwandlungstemperatur des härtbaren Harzes liegt bei 145°C (mittels TMA ermittelt).

## Patentansprüche

1. Verfahren zur Herstellung von Bauelementen für elektronische Geräte aus einem flächigen Trägermaterial, das durchgehende Bohrungen und Vertiefungen auf wenigstens einer Oberfläche aufweist, einer Zwischenschicht auf wenigstens einer Oberfläche des Trägermaterials, und einer auf besagter Schicht haftenden Metallfolie, umfassend die Schritte (a) Beschichten eines flächigen Trägermaterials mit einer die Zwischenschicht bildenden Zusammensetzung, (b) Aufbringen der Metallfolie auf die Beschichtung und (c) Verbinden der Teile unter Druck und Erwärmen, **dadurch gekennzeichnet, dass** man
(d) zuerst ein flüssiges, ein Lösungsmittel enthaltendes und thermisch härtbares Zweikomponentensystem aus wenigstens einem Härter und wenigstens einer härtbaren Verbindung formuliert,
(e) die Formulierung als Schicht auf wenigstens eine Oberfläche des Trägermaterials aufbringt,
(f) die aufgebrachte Schicht erwärmt, das Lösungsmittel entfernt und eine feste und trockene Schicht bildet, und
(g) danach eine Metallfolie auf die getrocknete Schicht aufbringt und das Trägermaterial, die Schicht und die Metallfolie mittels erhöhter Temperatur und erhöhtem Druck unter Härtung der Schicht fest miteinander verbindet.

2. Verfahren gemäss Anspruch 1, **dadurch gekennzeichnet, dass** die Metallfolie unmittelbar nach dem Trocknen auf die Zwischenschicht aufgebracht wird.

3. Verfahren gemäss Anspruch 1, **dadurch gekennzeichnet, dass** als Metallfolie eine Kupferfolie verwendet wird.

4. Verfahren gemäss Anspruch 1, **dadurch gekennzeichnet, dass** die Formulierung der Verfahrensstufe (d) eine Viskosität von kleiner als 20 Pa·s aufweist, gemessen bei 25 °C Brookfield.

5. Verfahren gemäss Anspruch 4, **dadurch gekennzeichnet, dass** die Viskosität 5 bis 15 Pa.s beträgt.

6. Verfahren gemäss Anspruch 1, **dadurch gekennzeichnet, dass** die Trocknung in der Stufe (f) bei einer Temperatur von nicht mehr als 100 °C vorgenommen wird.

7. Verfahren gemäss Anspruch 1, **dadurch gekennzeichnet, dass** die Trocknung während einer Dauer von 10 bis 120 Minuten vorgenommen wird.

8. Verfahren gemäss Anspruch 1, **dadurch gekennzeichnet, dass** es sich bei der härtbaren Verbindung in der Formulierung der Stufe (d) um eine Epoxidverbindung mit durchschnittlich mehr als einer Epoxidgruppe im Molekül handelt.

9. Verfahren gemäss Anspruch 8, **dadurch gekennzeichnet, dass** es sich bei der Epoxidverbindung um einen gegebenenfalls vorreagierten Diglycidylether eines Bisphenols oder um einen Epoxyphenolnovolak handelt.

10. Verfahren gemäss Anspruch 1, **dadurch gekennzeichnet, dass** der Härter in der Formulierung der Stufe (d) ausgewählt ist aus der Gruppe der Imidazole, Anhydride, Amide, Amine, Phenolharze und Cyanatester.

11. Verfahren gemäss Anspruch 1, **dadurch gekennzeichnet, dass** die Formulierung der Stufe (d) zusätzlich Härtungsbeschleuniger, Füllstoffe, Thixotropiemittel und Farbstoffe enthält.

## Claims

1. A method for the production of components for electronic apparatuses from a sheet-like substrate material which has through-holes and indentations on at least one surface, an intermediate layer on at least one surface of the substrate material, and a metal foil adhering to said layer, comprising steps (a) coating of a sheet-like substrate material with a composition forming the intermediate layer, (b) application of the metal foil to the coating and (c) bonding of the parts under pressure and heat, **characterized in that**
(d) first a liquid, solvent-containing and heat-curable two-component system is formulated from at least one curing agent and at least one curable compound,
(e) the formulation is applied as a layer to at least one surface of the substrate material,
(f) the applied layer is heated, the solvent is removed and a solid and dry layer forms, and
(g) thereafter a metal foil is applied to the dried layer and the substrate material, the layer and the metal foil are firmly bonded to one another by means of elevated temperature and elevated pressure with curing of the layer.

2. A method according to Claim 1, **characterized in that** the metal foil is applied to the intermediate layer immediately after drying.

3. A method according to Claim 1, **characterized in that** the metal foil used is a copper foil.

4. A method according to Claim 1, **characterized in that** the formulation of stage (d) for the method has a viscosity of less than 20 Pa·s, measured at 25°C according to Brookfield.

5. A method according to Claim 4, **characterized in that** the viscosity is from 5 to 15 Pa·s.

6. A method according to Claim 1, **characterized in that** the drying in stage (f) is carried out at a temperature of not more than 100°C.

7. A method according to Claim 1, **characterized in that** the drying is carried out for a duration of from 10 to 120 minutes.

8. A method according to Claim 1, **characterized in that** the curable compound in the formulation of stage (d) is an epoxide compound having on average more than one epoxide group in the molecule.

9. A method according to Claim 8, **characterized in that** the epoxide compound is an optionally prereacted diglycidyl ether of a bisphenol or is an epoxyphenol novolak.

10. A method according to Claim 1, **characterized in that** the curing agent in the formulation of stage (d) is selected from the group consisting of the imidazoles, anhydrides, amides, amines, phenol resins and cyanate esters.

11. A method according to Claim 1, **characterized in that** the formulation of stage (d) additionally contains curing accelerators, fillers, thixotropic agents and dyes.

## Revendications

1. Procédé de fabrication de composants pour appareils électroniques, constitués d'un matériau support de grande surface, qui présente au moins sur une surface des perforations et des renfoncements continus, d'une couche intermédiaire sur au moins une surface du matériau support et d'un film métallique adhérent sur ladite couche, comprenant les étapes consistant à : (a) revêtir un matériau support de grande surface avec une composition formant la couche intermédiaire, (b) déposer le film métallique sur le revêtement et (c) relier les parties sous pression et chauffage, **caractérisé en ce que** l'on
(d) formule d'abord un système bi-composant liquide thermodurcissable et contenant un solvant, constitué d'au moins un durcisseur et d'au moins un composé durcissable,
(e) dépose la formulation sous forme de couche sur au moins une surface du matériau support,
(f) réchauffe la couche déposée, élimine le solvant et forme une couche solide et sèche, et
(g) dépose ensuite un film métallique sur la couche séchée et relie solidement ensemble le matériau support, la couche et le film métallique au moyen de hautes températures et d'une pression accrue, en durcissant la couche.

2. Procédé selon la revendication 1, **caractérisé en ce que** le film métallique est déposé immédiatement après séchage sur la couche intermédiaire.

3. Procédé selon la revendication 1, **caractérisé en ce que** l'on utilise comme film métallique un film de cuivre.

4. Procédé selon la revendication 1, **caractérisé en ce que** la formulation de l'étape de procédé (d) présente une viscosité inférieure à 20 Pa.s, mesurée à 25°C sur un Brookfield.

5. Procédé selon la revendication 4, **caractérisé en ce que** la viscosité va de 5 à 15 Pa.s.

6. Procédé selon la revendication 1, **caractérisé en ce que** le séchage à l'étape (f) s'effectue à une température qui n'est pas supérieure à 100°C.

7. Procédé selon la revendication 1, **caractérisé en ce que** le séchage est opéré pendant une durée allant de 10 à 120 minutes.

8. Procédé selon la revendication 1, **caractérisé en ce que** le composé durcissable de la formulation de l'étape (d) est un composé époxyde ayant, en moyenne, plus d'un groupe époxyde dans la molécule.

9. Procédé selon la revendication 8, **caractérisé en ce que** le composé époxyde est un éther diglycidylique d'un bisphénol, le cas échéant ayant réagi au préalable, ou une novolaque d'époxyphénol.

10. Procédé selon la revendication 1, **caractérisé en ce que** le durcisseur dans la formulation de l'étape (d) est choisi dans le groupe des imidazols, anhydrides, amides, amines, résines phénoliques et esters de cyanate.

11. Procédé selon la revendication 1, **caractérisé en ce que** la formulation de l'étape (d) contient, en plus, des accélérateurs de durcissement, des charges, des agents thixotropes et des colorants.
